# DEMANDE DE BREVET EUROPEEN

(11) **EP 1 852 913 A1**
(43) Date de publication de la demande: **07.11.2007**
(21) Numéro de dépôt: 07290554.0
(22) Date de dépôt: 02.05.2007
(51) Int. Cl.: H01L 25/16, H01L 23/48, H01L 25/07

(54) **Macro-composant destiné à être monté dans un ensemble à empilement pressé et ensemble comportant un tel macro-composant**

(30) Priorité: 04.05.2006 FR 0604018
(71) Demandeur: Converteam SAS, 91300 Massy (FR)
(72) Inventeur: Bele, Joris, 75012 Paris (FR)
(74) Mandataire: Habasque, Etienne J. Jean-François

(57) **Abrégé**

L'invention concerne un macro-composant destiné à être monté dans un ensemble à empilement pressé et comportant un semi-conducteur.
Ce macro-composant comporte un dispositif de pilotage (48) et un boîtier d'alimentation (50) connectés à un élément à semi-conducteur (40). Ce macro-composant comporte un espace de réception longitudinal (62) dans lequel l'élément à semi-conducteur est logé et une portion (66) longitudinale en saillie comportant des moyens (70) de réception et de fixation desdits dispositif de pilotage (48) et boîtier d'alimentation (50). Ce macro-composant comporte en outre au moins un arceau (72) de montage sur des tirants d'assemblage de l'empilement.

## Description

La présente invention concerne un macro-composant destiné à être monté à l'aide de tirants dans un ensemble à empilement pressé et comportant un élément à semi-conducteur, et plus particulièrement un tel macro-composant comportant en outre :
- un dispositif de réception d'organes de pilotage et/ou d'alimentation d'un semi-conducteur, comportant un espace de réception transversal dans lequel l'élément à semi-conducteur est logé et une portion transversale en saillie comportant des moyens de réception et de fixation desdits organes; et
- un dispositif de pilotage un boîtier d'alimentation du semi-conducteur, connectés à l'élément à semi-conducteur et fixés à la portion en saillie.

On connaît un tel macro-composant par le document US-A-6140699. Dans ce document, le macro-composant est à son tour encliqueté sur une pièce moulée qui comprend des moyens de montage sur des organes d'assemblage. Une telle réalisation en deux parties du dispositif de réception est complexe et relativement fragile.

Des dispositifs de type approchant sont également décrits dans les documents EP-A-1178593 et EP-A-2886368.

Un module de puissance, comme par exemple celui destiné à fournir de l'énergie électrique à un convertisseur pour moteur de puissance supérieure au mégawatt, comprend des éléments empilés et comprimés sous une pression de plusieurs tonnes selon un axe d'empilement longitudinal. Ces ensembles, communément désignés sous le nom d'ensembles « press-pack », sont pressés au moyen de deux brides latérales externes solidarisées par deux tirants longitudinaux parallèles à l'axe d'empilement. Un tel module de puissance est communément désigné sous le nom de « pile ».

Une pile comporte généralement un ou plusieurs éléments à semi-conducteurs (ci-après désignés par « semi-conducteurs ») de puissance, chacun sous la forme d'une galette cylindrique comportant deux surfaces planes transversales circulaires parallèles opposées, comme par exemple une diode, un thyristor ou un transistor de puissance, et des circuits de refroidissement agencés de part et d'autre de chaque semi-conducteur.

Certains de ces semi-conducteurs de puissance, comme des transistors IEGT (acronyme anglais de « Injected Enhenced Gate Transistor »), nécessitent pour leur fonctionnement d'être pilotés et alimentés électriquement. A cette fin, chacun d'entre eux est connecté à organe de pilotage, ou driver, et à un boîtier d'alimentation électrique.

Toutefois, le remplacement d'un transistor défectueux dans une pile nécessite aujourd'hui de préalablement déconnecter celui-ci de ses organes associés et ensuite de reconnecter le transistor de remplacement avec ces organes. Or, l'espace libre dans une pile pour atteindre ces connexions est restreint, rendant ainsi la manoeuvre de connexion/déconnexion fastidieuse.

En outre, les drivers et boîtier d'alimentation sont généralement déportés à distance de la pile car il n'existe pas d'emplacement réellement satisfaisant pour ceux-ci. Les connexions électriques sont ainsi rallongées, ce qui peut être dommageable pour le fonctionnement d'un transistor IEGT.

Enfin, un transistor IEGT étant aujourd'hui livré seul, il est nécessaire d'utiliser des systèmes d'anti-dépôt d'électricité statique sur leur surface pour éviter qu'un court-circuit ne se produise lors de leur montage dans une pile et ne les endommage.

Le but de la présente invention est de résoudre les problèmes susmentionnés en proposant un dispositif de réception du driver et du boîtier d'alimentation d'un transistor de puissance qui soit robuste et simple et qui permette en outre une maintenance facilitée d'une pile.

A cet effet, l'invention a pour objet un macro-composant destiné à être monté à l'aide de tirants dans un ensemble à empilement pressé et comportant :
- un élément à semi-conducteur ;
- un dispositif de réception d'organes de pilotage et/ou d'alimentation d'un semi-conducteur, comportant un espace de réception transversal dans lequel l'élément à semi-conducteur est logé et une portion transversale en saillie comportant des moyens de réception et de fixation desdits organes; et
- un dispositif de pilotage un boîtier d'alimentation du semi-conducteur, connectés à l'élément à semi-conducteur et fixés à la portion en saillie ;
   ledit macro-composant comportant en outre au moins un arceau de montage sur des tirants d'assemblage de l'empilement.

Selon des modes de réalisation particuliers :
- ledit macro-composant comporte une poignée ;
- le dispositif est constitué d'une résine ;
- l'élément à semi-conducteur est un transistor IEGT ou IGBT, de type press-pack.

L'invention a également pour objet un ensemble à empilement pressé, caractérisé en ce qu'il comporte au moins un macro-composant du type précité, ledit macro-composant étant apte à être connecté à une source électrique pour l'alimentation électrique du boîtier d'alimentation du semi-conducteur et à un automate de commande de commutation pour la réception de commande de commutation du semi-conducteur par le dispositif de pilotage.

L'invention sera mieux comprise à la lecture de la description qui va suivre, donnée uniquement à titre d'exemple, et faite en relation avec les dessins annexés, dans lesquels des références identiques désignent des éléments identiques ou analogues, et dans lesquels :
- la figure 1 est une vue en perspective d'un module de puissance comprenant un empilement d'ensembles press-pack comportant des dispositifs selon l'invention ;
- la figure 2 est une vue de face du module de puissance de la figure 1 ;
- la figure 3 est une vue en perspective d'un dispositif selon l'invention entrant dans la constitution du module des figures 1 et 2 ; et
- la figure 4 est une vue en perspective d'une pièce du dispositif de la figure 3 ; et
- la figure 5 est une vue en perspective d'un gabarit de centrage selon l'invention.

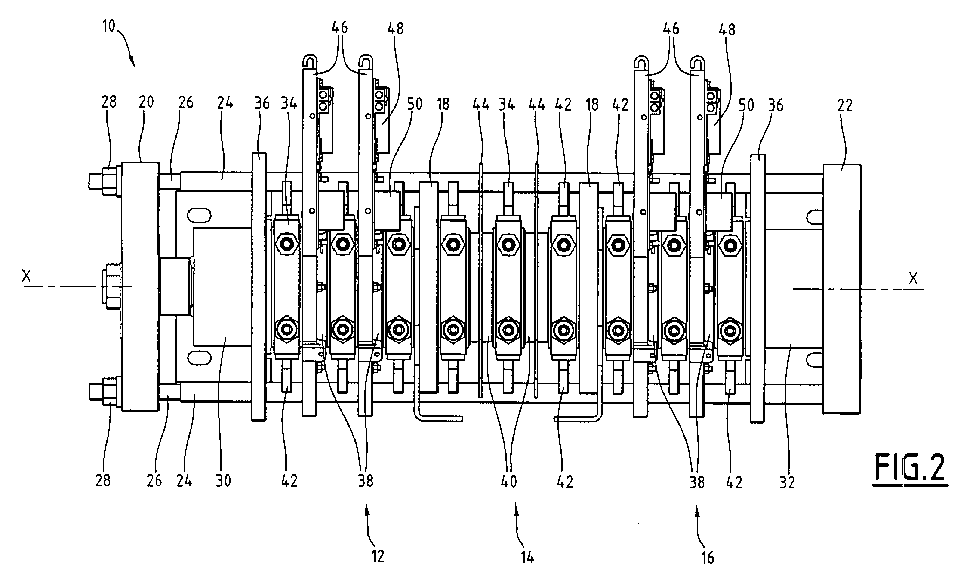

Dans ce qui suit, le terme « longitudinal » se rapportera à des droites et plans parallèles à l'axe d'empilement X-X illustré à la figure 2, et le terme « transversal » se rapportera à des droites et plans orthogonaux à l'axe d'empilement X-X.

Sur les dessins, les proportions des objets représentés sont conformes à la réalité.

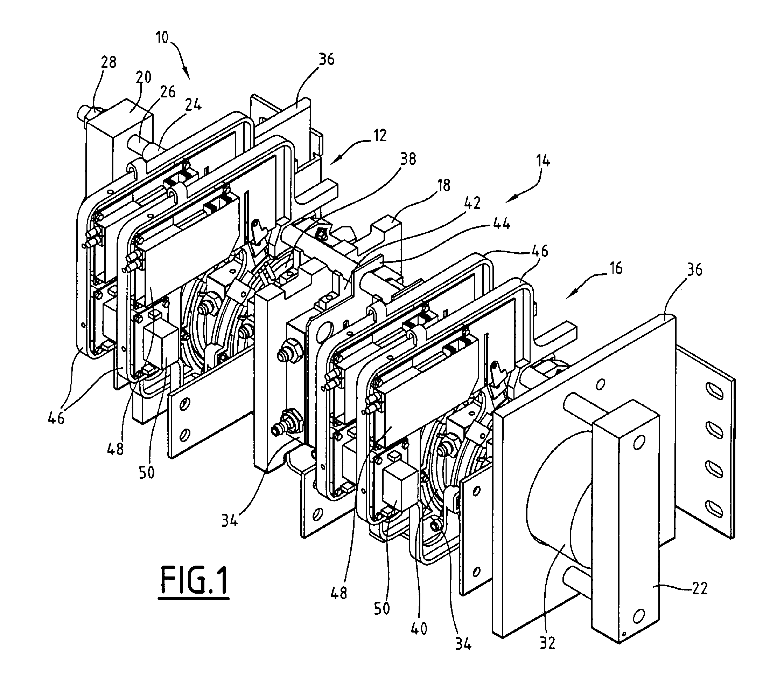

Sur les figures 1 et 2, il est représenté une pile à IEGT ou IGBT 10 destinée à fournir de l'énergie électrique à un convertisseur de moteur d'une puissance supérieure au mégawatt.

La pile 10 comporte six ensembles press-pack 12, 14, 16 séparés par des plaques isolantes 18 conductrices. Ces ensembles press-pack 12, 14, 16 sont empilés selon un axe longitudinal X-X sous une pression de plusieurs tonnes exercée par un système de mise en pression. Ce système comporte deux brides de serrage 20, 22 agencées de part et d'autre des ensembles press-pack et fixées l'une à l'autre par deux tirants cylindriques longitudinaux 24 parallèles à l'axe d'empilement X-X et à égale distance de celui-ci.

Chaque tirant longitudinal 24 comporte une extrémité encastrée dans l'une des brides de serrage 22 et l'autre de ses extrémités comporte un filetage 46 s'engageant dans un trou traversant correspondant formé dans l'autre bride 22 de serrage, et sur lequel vient se visser un boulon 28.

Le système de mise en pression comprend enfin un organe 30, 32 de répartition homogène de pression agencé entre chaque bride de serrage 20, 22 et une surface longitudinale d'un circuit de refroidissement 34 agencé au début ou à la fin de la pile 10. Ces organes 30, 32 de répartition de pression ont pour effet de transférer de façon homogène la pression exercée par les brides de serrage 20, 22, au moyen du vissage des boulons 28 sur les filets 26 des tirants 24, aux surfaces des circuits de refroidissement 34 avec lesquelles ils sont en contact.

Enfin, la pile 10 comporte des équerres de support 36 traversées par les tirants 24 et les organes 30, 32 de répartition de pression et permettant de fixer la pile 10 à un bâti (non représenté).

Un ensemble press-pack 12, 14, 16 comporte un empilement selon l'axe X-X de deux semi-conducteurs 38, 40, et plus particulièrement des diodes de puissance 38 ou des transistors IEGT ou IGBT de puissance 40, et de circuits de refroidissement 34 connectés à un système de circulation d'eau (non représenté), chaque semi-conducteur 38, 40 étant interposé entre deux circuits de refroidissement 34. Des transistors IEGT seront considérés comme exemples dans la suite.

Comme cela est connu en soi, un semi-conducteur 38, 40 présente la forme d'une galette cylindrique, un transistor IEGT étant en outre pourvu d'une collerette circulaire transversale périphérique.

Chaque semi-conducteur 38, 40 et chaque circuit de refroidissement 34 d'un ensemble press-pack 12, 14, 16 comporte des surfaces avant et arrière transversales circulaires et concentriques, ces surfaces de l'élément étant en contact avec des surfaces transversales circulaires correspondantes d'éléments qui lui sont adjacents.

On désignera par la suite par axe « central », l'axe longitudinal d'un élément, passant par les centres des surfaces circulaires de celui-ci. Par centrage, on entendra par la suite l'alignement de l'axe central d'un élément des ensembles press-pack avec l'axe d'empilement X-X.

Chaque circuit de refroidissement 34 comporte deux arceaux latéraux opposés 42 dans lesquels sont respectivement engagés les tirants longitudinaux 24 de sorte que le circuit de refroidissement 34 est sensiblement centré sur l'axe d'empilement X-X.

Les circuits de refroidissement 34 étant des éléments présentant un taux de défaillance faible, ils restent à demeure dans la pile 10. Leur centrage sur l'axe X-X est donc réalisé avec précision lors de la fabrication de la pile 10.

Les diodes 38 et les transistors IEGT 40 étant plus fragiles, ils nécessitent d'être régulièrement remplacés.

L'extraction d'une diode défectueuse, le positionnement et le centrage d'une nouvelle diode de remplacement sont réalisés à l'aide de sucettes de centrage/extraction 44 classiques associées aux diodes 38. Une telle sucette 44 garantit le centrage d'une diode 38 avec une précision d'un à deux millimètres, ce qui s'avère suffisant pour un fonctionnement satisfaisant de celle-ci.

Le remplacement d'un transistor IEGT défectueux, le positionnement et le centrage d'un nouveau transistor IEGT de remplacement sont quant à eux réalisés à l'aide de sucettes d'extraction/centrage 46 selon l'invention associées à chaque transistor IEGT 40. Une telle sucette 46 permet un centrage plus précis du transistor IEGT qui lui est associé.

Par ailleurs, une sucette 46 selon l'invention comporte également des logements pour la réception d'un organe 48 de pilotage, ou driver, et d'un boîtier d'alimentation 50 du transistor IEGT 40.

Un transistor IEGT 40 forme, avec sa sucette d'extraction/centrage 46, son driver 48 et son boîtier d'alimentation 50, un ensemble, ou macro-composant IEGT, de faible encombrement, avec des connexions électriques courtes et protégeant le transistor IEGT 40 de dépôt d'électricité statique sur ses surfaces. Ce macro-composant et la sucette 46 selon l'invention seront expliqués plus en détail par la suite.

Il est à noter qu'aucun système de centrage utilisant des goupilles de centrage n'est ainsi nécessaire pour centrer les divers semi-conducteurs 38, 40 de la pile 10 sur l'axe X-X.

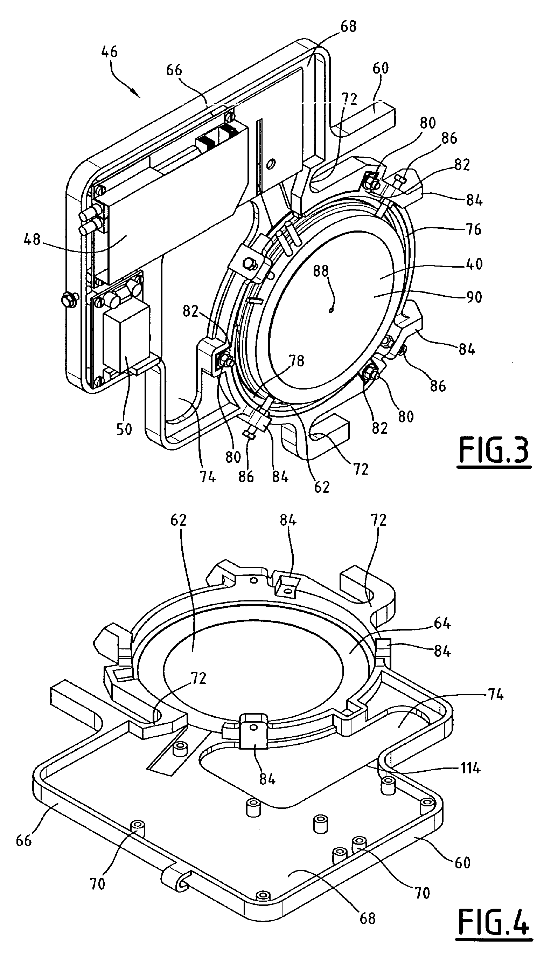

Il va maintenant être décrit en relation avec les figures 3 et 4 un macro-composant IEGT et une sucette d'extraction/centrage 40 selon l'invention.

La sucette 46 comporte une plaque 60 moulée par injection en une résine et isolante. Cette plaque 60 est pourvue d'un espace transversal 62 ouvert circulaire de diamètre supérieur à celui du transistor 40 et dans lequel vient se loger ce dernier. L'espace 62 est partiellement fermé sur l'un de ses cotés transversaux par une collerette 64 définissant une ouverture circulaire de diamètre inférieur à celui du transistor 40.

La plaque 60 comprend également un rebord transversal en saillie 66 sur une surface transversale 68 duquel sont prévus des plots cylindriques 70 creux pourvus de filets internes pour la réception et la fixation par vissage du driver 48 et du boîtier d'alimentation 50.

La plaque 60 comporte également deux arceaux latéraux 72 dans lesquels se logent les tirants 24 lorsque la sucette 46 associée à son transistor IEGT 40 sont montés dans la pile 10. Une poignée 74 est par ailleurs formée dans la plaque 60 au moyen d'un évidement dans le rebord en saillie 66.

La sucette 46 comporte également une bride circulaire amovible 76 moulée par injection dans le même matériau que la plaque 60. La bride 76 presse la collerette circulaire transversale périphérique 78 du transistor IEGT 40 sur la collerette 64 de la pièce 60, ceci étant réalisé au moyen d'un système 80 à vis et écrous solidarisant des languettes périphériques 82 de la bride circulaire 76 avec sur une surface transversale de la plaque 60. Le transistor IEGT 40 est ainsi immobilisé longitudinalement dans l'espace 62.

La plaque 60 comprend par ailleurs trois portions longitudinales 84 pourvues de trous dans lesquels sont respectivement insérés trois ensembles de vis et d'écrou 86. Les vis de ensembles 86 sont suffisamment longues pour venir au contact de la tranche du transistor IEGT 40 de sorte qu'il est possible en les vissant et dévissant de régler et bloquer la position transversale les centres 88 des surfaces avant et arrière 90 du transistor IEGT dans l'espace 62 de la pièce 60.

Selon l'invention, l'axe central du transistor IEGT 40 est pré-positionné dans l'espace 62 sur un axe longitudinal de la sucette 46 que l'on sait être confondu, avec une précision inférieure à 0,5 millimètres et de préférence avec une précision de 0,1 à 0,2 millimètres, avec l'axe d'empilement X-X de la pile 10 une fois l'ensemble sucette/transistor monté dans celle-ci.

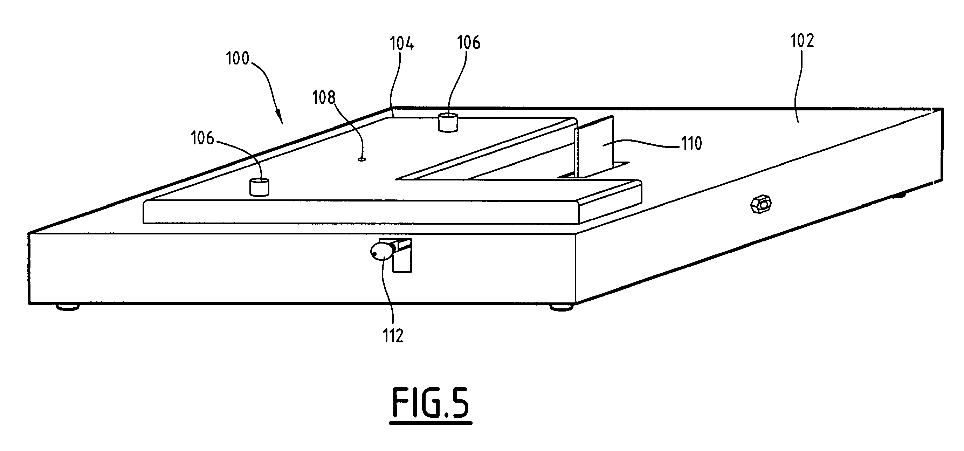

Par exemple, il est possible pour cela d'utiliser un gabarit de centrage 100 tel qu'illustré à la figure 5. L'utilisation du gabarit 100 pour le positionnement du transistor IEGT 40 dans l'espace 62 de la sucette se fonde sur la caractéristique selon laquelle un transistor IEGT comprend généralement un trou sur chacune de leur surface longitudinale, ces trous étant agencés au niveau de l'axe central du transistor.

Le gabarit de centrage 100 comporte un bâti plan 102 sur lequel est fixée une plaque de centrage 104 comportant deux plots cylindriques 106, de même diamètre que celui des tirants 24 de la pile 10 et espacés de la même distance que ceux-ci.

La plaque 104 est également pourvue d'un trou cylindrique 108 agencé entre les deux plots 106 au niveau d'un axe du gabarit 100 correspondant à l'axe d'empilement X-X de la pile 10, et de diamètre égal à celui des trous centraux du transistor IEGT.

Enfin, le gabarit de centrage 100 comporte une lame de calage 110 rétractable dans le bâti 102 et manoeuvrable par un levier 112 par des moyens appropriés (non représentés).

Les dimensions, la forme et l'agencement de la plaque de centrage 104 et de la lame de calage 110 sont choisis par que la plaque 60 de la sucette 46 puisse reposer à plat sur la plaque 104 avec les plots 106 engagés dans les arceaux 72, et avec une surface interne 114 de la poignée 74 calée contre la lame 110 pour que la plaque 60 soit immobilisée sur le gabarit 100 dans une position correspondante à celle qu'elle aurait si elle était montée sur la pile 10.

Le montage du transistor 40 dans la sucette 46 est alors le suivant.

La plaque 60 est montée sur le gabarit 100 en logeant les plots 102 dans les arceaux 72 de celle-ci.

Une goupille est alors insérée partiellement dans le trou 108 de la plaque de centrage 104 de sorte qu'une portion de celle-ci fait saillie de la plaque 104.

Le transistor IEGT 40 est ensuite logé dans l'espace 62 de la plaque 60 avec la portion en saillie de la goupille engagée dans le trou central correspondant du transistor IEGT 40.

Le transistor 40 est alors immobilisé transversalement dans l'espace 62 au moyen des ensembles de vis/boulons 86. L'axe central du transistor 40 est ainsi positionné sur un axe longitudinal de la plaque 60 sensiblement confondu avec l'axe X-X lorsque le transistor est monté dans la pile 10. On remarquera que cet axe de la plaque 60 sur lequel est positionné l'axe du transistor 40 n'est pas nécessairement l'axe central de l'espace circulaire 62 du fait, par exemple, des tolérances de fabrication de la plaque 60.

La bride amovible 76 est ensuite vissée sur la plaque 60 pour immobiliser longitudinalement le transistor 40 dans l'espace 62.

Le driver 48 et le boîtier d'alimentation 50 sont alors montés sur la plaque 60 et les connexions électriques (non représentées) entre le transistor IEGT 40, et ceux-ci sont réalisés, finalisant de ce fait le montage du macro-composant qui est alors retiré du gabarit 100.

Les ensembles vis/boulons 86 maintiennent ainsi le transistor IEGT 40 dans une position de l'espace 62 correspondant à un centrage avec l'axe X-X de la pile 10.

La connexion préalable du transistor 40 avec son driver 48 et son boîtier d'alimentation 50 évite une connexion fastidieuse des ces éléments dans la pile 10. De plus, le fait que le transistor IEGT 40 soit connecté à son boîtier d'alimentation 50 empêche le dépôt d'électricité statique sur les surfaces de celui-ci, ce qui évite d'avoir à utiliser les systèmes de l'état de la technique ayant la même fonction mais généralement difficilement retirables une fois le transistor monté dans la pile.

Ainsi, l'opérateur montant dans la pile 10 le macro-composant formé du transistor 40, de la sucette 46, du driver 48 et du boîtier 50 n'a plus qu'à établir les connexions du driver 48 et du boîtier 50 avec leur environnement, c'est-à-dire une connexion électrique du boîtier 48 avec une source d'alimentation électrique et une connexion par fibres optiques du driver 50 avec un automate de commande de commutation du transistor IEGT 40 pour la réception par le driver 50 de signaux de commande de commutation du transistor 40.

Les emplacements du driver 48 et du boîtier 50 dans la plaque 60 sont choisis pour que leur connexion au transistor IEGT 40 soit courte. Ainsi l'encombrement total du macro-composant est réduit, ce dernier présentant en outre une épaisseur faible qui facilite la manipulation de la pile 10.

De manière avantageuse, le macro-composant sera vendu tel quel. Ainsi, le remplacement d'un transistor défectueux est facilité puisqu'un opérateur de maintenance n'a qu'à déconnecter le driver et le boîtier d'alimentation de celui-ci, puis à connecter le driver et le boîtier du macro-composant nouvellement monté dans la pile en remplacement de l'ancien défectueux.

Pour extraire un semi-conducteur 38, 40 défectueux de la pile 10, les boulons 28 de la pile 10 sont dévissés, relâchant de ce fait la pression exercée sur les ensembles press-pack 12, 14, 16. Le semi conducteur est ainsi extractible en tirant longitudinalement la sucette qui lui est associé, sans démonter l'ensemble de la pile 10 comme cela est le cas des systèmes de centrage utilisant des goupilles de centrage.

## Revendications

1. Macro-composant destiné à être monté à l'aide de tirants dans un ensemble à empilement pressé (10), et comportant un élément semi-conducteur, comportant :
- un dispositif (46) de réception d'organes (48, 50) de pilotage et/ou d'alimentation d'un semi-conducteur (40), comportant un espace de réception transversal (62) dans lequel l'élément à semi-conducteur est logé et une portion (66) transversale en saillie comportant des moyens (70) de réception et de fixation desdits organes (48, 50) ; et
- un dispositif de pilotage (48) et un boîtier d'alimentation (50) du semi-conducteur (40), connectés à l'élément à semi-conducteur (40) et fixés à la portion en saillie (66) ;
**caractérisé en ce qu'**il comporte en outre au moins un arceau (72) de montage sur des tirants d'assemblage de l'empilement.

2. Macro-composant selon la revendication 1, **caractérisé en ce qu'**il comporte une poignée (74).

3. Macro-composant selon la revendication 1 ou 2, **caractérisé en ce que** le dispositif est constitué d'une résine.

4. Macro-composant selon l'une quelconque des revendications 1 à 3, **caractérisé en ce que** l'élément à semi-conducteur (40) est un transistor IEGT ou IGBT, de type press-pack.

5. Ensemble à empilement pressé (10), **caractérisé en ce qu'**il comporte au moins un macro-composant conforme à l'une quelconque des revendications précédentes, ledit macro-composant étant apte à être connecté à une source électrique pour l'alimentation électrique du boîtier d'alimentation (50) de l'élément semi-conducteur et à un automate de commande de commutation pour la réception de commande de commutation de l'élément à semi-conducteur par le dispositif de pilotage (48).
